# EUROPÄISCHE PATENTSCHRIFT

(11) **EP 3 257 338 B1**
(45) Veröffentlichungstag und Bekanntmachung des Hinweises auf die Patenterteilung: **09.01.2019**
(21) Anmeldenummer: 16714347.8
(22) Anmeldetag: 29.03.2016
(51) Int. Cl.: H05K 3/34, B23K 1/00, B23K 1/008, H05K 3/22, B23K 101/42

(54) **HEIZELEMENT FÜR DIE SMD-MONTAGE, ELEKTRONISCHE BAUGRUPPE MIT EINEM SOLCHEN HEIZELEMENT UND VERFAHREN ZUM ERZEUGEN EINER ELEKTRONISCHEN BAUGRUPPE**
HEATING ELEMENT FOR SMD MOUNTING, ELECTRONIC ASSEMBLY HAVING SUCH A HEATING ELEMENT, AND METHOD FOR PRODUCING AN ELECTRONIC ASSEMBLY
ÉLÉMENT CHAUFFANT POUR LE MONTAGE DE CMS, MODULE ÉLECTRONIQUE PRÉSENTANT UN TEL ÉLÉMENT CHAUFFANT ET PROCÉDÉ POUR LA FABRICATION D'UN MODULE ÉLECTRONIQUE

(30) Priorität: 31.03.2015 DE 102015205820
(43) Veröffentlichungstag der Anmeldung: 20.12.2017
(73) Patentinhaber: Siemens Aktiengesellschaft, 80333 München (DE); Kleb- und Gießharztechnik Dr. Ludeck GmbH, 15370 Vogelsdorf (DE)
(72) Erfinder: LUDECK, Wolfgang, 12623 Berlin (DE); PRIHODOVSKY, Andrey, 95448 Bayreuth (DE); HANISCH, Michael, 16540 Hohen Neuendorf (DE); MÜLLER, Bernd, 16259 Falkenberg (DE); WITTREICH, Ulrich, 16727 Velten (DE); WORMUTH, Dirk, 12203 Berlin (DE); HUTH, Heiko, 18055 Rostock (DE); NOWOTTNICK, Mathias, 18059 Rostock (DE); SEEHASE, Dirk, 18057 Rostock (DE)
(74) Vertreter: Maier, Daniel Oliver
(86) Internationale Anmeldenummer: PCT/EP2016/056775
(87) Internationale Veröffentlichungsnummer: WO 2016/156299

(56) Entgegenhaltungen:
- DE-A1-102008 031 633
- DE-A1-102011 116 259
- DE-C1- 10 131 014
- JP-A- S61 111 765
- US-A- 3 220 630

## Beschreibung

Die Erfindung betrifft ein Heizelement mit einer Montageseite für eine SMD-Montage, wobei die Montageseite zum Aufsetzen auf ein Substrat, beispielsweise in Form eines Schaltungsträgers zur Verfügung steht. Weiterhin betrifft die Erfindung eine elektronische Baugruppe, welche einen Schaltungsträger und ein Bauelement aufweist. Zuletzt betrifft die Erfindung ein Verfahren zum Erzeugen einer elektronischen Baugruppe mit einem Schaltungsträger und einem Bauelement, wobei das Bauelement auf dem Schaltungsträger platziert wird. Anschließend werden elektrische Kontakte zwischen dem Schaltungsträger und dem Bauelement durch eine Temperaturerhöhung bei einer charakteristischen Fügetemperatur ausgebildet. Typischerweise handelt es sich bei den elektrischen Kontakten um Lötverbindungen, wobei die Temperaturerhöhung im Verlauf des Verfahrens dazu führt, dass der Lotwerkstoff bei der Fügetemperatur aufschmilzt. Dabei liegt die Fügetemperatur etwas oberhalb der Schmelztemperatur des Lotwerkstoffes. Denkbar sind allerdings auch andere Werkstoffe zur Ausbildung des Kontaktes. Beispielsweise kann ein elektrisch leitfähiger Leitkleber Verwendung finden, der bei der Fügetemperatur aushärtet.

Die Verfahren zur Herstellung elektronischer Baugruppen sind weltweit etabliert. Zur Herstellung der Kontakte zwischen Schaltungsträger und Bauelementen werden verschiedene thermische Prozesse, insbesondere Lötverfahren, verwendet. Die thermischen Prozesse sind während der Fertigung auch für eine thermische Belastung der in der Fertigung befindlichen elektronischen Baugruppe verantwortlich. Um zum Beispiel thermisch besonders empfindliche Bauelemente zu schützen, müssen daher häufig modifizierte Lötverfahren angewendet werden, die beispielsweise mehrstufig ablaufen. Hierdurch entstehen allerdings zusätzliche Fertigungs- und Montagekosten. Ein weiteres Problem ergibt sich, wenn die zu fertigende elektronische Baugruppe hinsichtlich ihrer Wärmeleiteigenschaften und Wärmekapazität heterogen ist. Bei der Anwendung eines thermischen Fügeverfahrens für die auszubildenden Kontakte kommt es dann in der Fertigungseinrichtung wie zum Beispiel dem Lötofen zu einer unterschiedlich starken Erwärmung innerhalb der elektronischen Baugruppe. Dies kann zur Ausbildung zusätzlicher Spannungen führen und somit die Zuverlässigkeit der gefertigten elektronischen Baugruppe verringern. Diesen Effekten kann zwar dadurch entgegengewirkt werden, dass die Erwärmungszeiten für die zu fertigenden elektronischen Baugruppen verlängert werden, damit sich die Wärme in der Baugruppe besser verteilen kann, jedoch hat dies auch längere Durchsatzzeiten in der Fertigungsanlage zur Folge, wodurch die Wirtschaftlichkeit des Verfahrens verringert wird.

Ein Lösungsansatz zur Verbesserung des Wärmeverhaltens besteht darin, zusätzlich zu der durch die Fertigungsanlage aufgebrachten Wärme, die von außen in die zu fertigende elektronische Baugruppe eingebracht wird, eine Wärmequelle zur Verfügung zu stellen, die Wärme in der zu fertigenden elektrischen Baugruppe selbst erzeugt. Gemäß der US 2004/0149372 A1 wird beispielsweise vorgeschlagen, dass reaktive Folien in plattenförmigen Bauteilen wie zum Beispiel als Leiterplatte ausgeführten Schaltungsträgern vorgesehen werden können, die unter bestimmten Bedingungen Wärme in dem plattenförmigen Bauteil erzeugen. Eine zu fertigende elektronische Baugruppe könnte damit sozusagen von innen heraus erwärmt werden, wobei diese Wärme die von außen eingebrachte Wärme der Fertigungseinrichtung ergänzen könnte. Eine andere Maßnahme wird gemäß der DE 10 2009 013 919 A1 vorgeschlagen. In diesem Fall wird ein reaktives Lotmaterial als Material für die sich ausbildenden elektrischen Kontakte verwendet. Diesem Material ist eine reaktive Komponente beigegeben, welche bei einer Reaktionstemperatur exotherm reagiert und somit Wärme zur Verfügung stellt. Diese Wärme steht direkt in den auszubildenden Lötverbindungen zur Verfügung, weswegen diese stärker erwärmt werden als die restliche elektronische Baugruppe. Die Fertigungseinrichtung kann daher mit einer geringeren Temperatur betrieben werden, wobei die in dem Lotmaterial vorliegende Wärmemenge insgesamt ausreicht, um zu einem Aufschmelzen des Lotes beizutragen.

Die reaktiven Materialien werden im Rahmen der exothermen Reaktionen in ein Reaktionsprodukt umgewandelt. Dieses verbleibt zumindest in Resten auf dem Schaltungsträger oder in dem ausgebildeten Kontakt (d. h. der Lötverbindung). Dabei kann es die Qualität des Produktionsergebnisses beeinträchtigen. Man könnte diesen Nachteil dadurch vermeiden, dass man statt einer reaktiven Substanz eine andere thermische Energiequelle zur Verfügung stellt. Es würden sich beispielsweise elektrische Heizelemente anbieten, welche im Wesentlichen aus einem Heizdraht bestehen, der in den fraglichen Regionen der elektronischen Baugruppe zusätzliche Wärme erzeugen kann. Allerdings muss die Herstellung des Heizdrahtes in dem Montageprozess für die elektronische Baugruppe berücksichtigt werden und schafft aufgrund der Notwendigkeit einer elektrischen Kontaktierung einen nicht zu vernachlässigenden Mehraufwand bei Fertigung und Montage. Die Kontaktierung muss auch aufrechterhalten werden, während die elektronische Baugruppe der Fertigungseinrichtung bewegt wird, wodurch der Fertigungsaufwand weiter steigt.

Gemäß der JP S61 111765 A ist beschrieben, dass bei einem Verfahren zum Erzeugen einer elektronischen Baugruppe ein Bauelement auf einem zugehörigen Schaltungsträger platziert werden kann. Die elektrischen Kontakte zwischen dem Schaltungsträger und dem Bauelement können dann durch eine Temperaturerhöhung ausgebildet werden, wobei in der sich ausbildenden Lötverbindung eine reaktive Substanz vorgesehen ist. Diese reagiert bereits bei einer Temperatur, die kleiner als die Fügetemperatur ist, so dass die aus der exothermen Reaktion resultierende Reaktionswärme zum Ausbilden der Lötverbindung genutzt werden kann.

Gemäß der US 3,220,630 ist ein Heizelement beschrieben, welches einen Hohlraum aufweist. In diesem ist eine reaktive Substanz eingeschlossen, welche bei einer bestimmten Reaktionstemperatur exotherm reagiert. Mit diesem Heizelement können beispielsweise Rohre miteinander verbunden werden. Somit ist das Heizelement an die Außenseite der Rohre angepasst.

Gemäß der DE 101 31 014 C1 ist beschrieben, dass ein Bauelement mit einer Montageseite und einem Gehäuse mit einer Kavität für eine SMD-Montage vorgesehen werden kann. In der Kavität kann eine reaktive Substanz bei einer bestimmten Reaktionstemperatur exotherm reagieren. Bei dem Bauelement handelt es sich um ein Halbleiterbauelement oder einen Chip.

Gemäß der DE 10 2008 031 633 A1 ist eine Anordnung offenbart, mit der sich elektrische Bauelemente auf einen Träger befestigen lassen. Die Teilflächen, auf denen das elektrische Bauelement befestigt werden soll, können mit Zündelementen elektrisch verbunden sein, wobei die Zündelemente mit einer Anregungsenergie beaufschlagt werden können, um einen Anschluss des Bauelements zu bewirken.

Gemäß der DE 10 2011 116 259 A1 ist beschrieben, dass eine auf einen Substrat aufgebrachte folienförmige Antenne über ein exotherm reagierendes Material mit Antennenanschlüssen elektrisch verbunden werden kann. Zu diesem Zweck wird das exotherm reagierende Material aktiviert, so dass die Reaktionswärme eine stoffschlüssige metallische Verbindung erzeugt.

In Bezug auf die oben genannten Problemstellungen ergibt sich die Aufgabe, ein Heizelement anzugeben, mit dem bei vergleichsweise geringem Fertigungs- und Montageaufwand eine lokale Beheizung einer zu fertigenden elektronischen Baugruppe ermöglicht wird. Außerdem besteht die Aufgabe der Erfindung darin, eine elektronische Baugruppe derart fortzubilden, dass eine lokale Beheizung derselben bei vergleichsweise geringem Fertigungs- und Montageaufwand möglich ist. Die Aufgabe besteht überdies darin, ein Verfahren zum Erzeugen einer elektronischen Baugruppe derart weiterzubilden, dass die Baugruppe während des Fertigungsprozesses mit vergleichsweise geringem Fertigungs- und Montageaufwand lokal beheizt werden kann.

Die Aufgabe wird erfindungsgemäß mit dem eingangs angegebenen Heizelement dadurch gelöst, dass das Heizelement ein Gehäuse aufweist, welches eine Kavität umschließt, in der sich eine reaktive Substanz befindet. Diese Substanz reagiert bei einer Reaktionstemperatur T₁ exotherm.

Das Heizelement kann vorteilhaft mit seiner Montageseite auf einen Schaltungsträger aufgesetzt werden. Hierbei können die für die SMD-Montage üblichen Fertigungsverfahren zum Einsatz kommen. Da der Schaltungsträger ohnehin mit Bauelementen bestückt werden muss, lässt sich im Rahmen dieser Bestückung auch eine Bestückung mit dem erfindungsgemäßen Heizelement vornehmen. Hierbei entsteht nur ein unwesentlich höherer Fertigungs- und Montageaufwand. Damit eine Bestückung mit dem erfindungsgemäßen Heizelement in den üblichen Bestückprozess für die elektronische Baugruppe integriert werden kann, können die Heizelemente auch in den üblichen Anlieferungsformen verarbeitet werden. Die Heizelemente können gegurtet oder in Trays angeboten werden, so dass ein Greifen im Bestückautomaten vereinfacht wird.

In gleicher Weise wird die Aufgabe auch durch die oben angegebene elektronische Baugruppe gelöst, die im Rahmen eines Bestückprozesses mit dem erfindungsgemäßen Heizelement bestückt wurde. Das Heizelement kann beispielsweise in einer Region mit einer hohen Wärmekapazität montiert werden, damit hierdurch einer im Vergleich zu anderen Regionen der elektronischen Baugruppe erforderlichen längeren Erwärmungszeit in der Fertigungsanlage entgegengewirkt wird. Eine andere Möglichkeit besteht darin, das Heizelement bevorzugt in der Nähe von auszubildenden Kontakten unterzubringen, da dort die Wärme für das thermische Verfahren zum Ausbilden der Kontakte benötigt wird. Dies hat den Vorteil, dass die restliche elektronische Baugruppe nicht so stark erhitzt werden muss, da die Fügetemperatur T₃ nicht allein durch den Wärmeeintrag aus der Fertigungseinrichtung in die zu fertigende elektronische Baugruppe erreicht werden muss.

Die Aufgabe wird auch durch das eingangs angegeben Verfahren gelöst, wonach vor dem Ausbilden der elektrischen Kontakte ein Heizelement auf der elektronischen Baugruppe befestigt wird. Dieses Heizelement weist eine Kavität auf, in der eine reaktive Substanz vorgesehen ist, die bei einer Reaktionstemperatur T₁ exotherm reagiert. Erfindungsgemäß ist sichergestellt, dass die Reaktionstemperatur T₁ kleiner ist, als die Fügetemperatur T₃, bei der sich die elektrischen Kontakte ausbilden. Die aus der exothermen Reaktion der reaktiven Substanz resultierende Reaktionswärme wird vom Heizelement auf die sich ausbildenden elektrischen Kontakte übertragen. Dies wird dadurch sichergestellt, dass sich die elektrischen Kontakte im thermischen Wirkungsbereich des Heizelementes befinden.

Mit anderen Worten ist das Heizelement genügend nahe an den auszubildenden elektrischen Kontakten angeordnet, damit die im Heizelement entstehende Wärme auf die auszubildenden elektrischen Kontakte übertragen werden kann. Vorteilhaft muss dann weniger Wärme aus dem thermischen Fügeprozess durch die Fertigungseinrichtung, beispielsweise dem Lötofen, aufgebracht werden. Wie groß der Abstand zwischen dem Heizelement und den auszubildenden elektrischen Kontakten im Anwendungsfall gewählt werden muss, hängt von den Rahmenbedingungen ab. Zu berücksichtigen ist hierbei die erzeugte Wärmemenge des Heizelementes, die Wärmeleitfähigkeit der Strukturen, die sich zwischen dem Heizelement und den auszubildenden Kontakten befinden, und der Betrag der Temperaturerhöhung, die mit dem Heizelement erreicht werden soll. Beispielsweise kann gefordert werden, dass die Temperaturerhöhung in den Kontaktelementen, die durch das Heizelement bewirkt wird, wenigstens 10°C oder wenigstens 5 % der Fügetemperatur betragen soll.

Eine genügende Wärmeübertragung kann beispielsweise dadurch gewährleistet werden, dass das Heizelement gemäß einer Ausgestaltung der Erfindung dem Bauelement benachbart auf dem Schaltungsträger befestigt ist. Damit wird die Wärmeübertragung zwischen dem Bauelement und dem Heizelement nicht durch andere Bauelemente gestört und kann vorteilhaft über kurze Verbindungswege realisiert werden. Eine andere vorteilhafte Möglichkeit der Anordnung des Heizelementes kann bei plattenförmigen Schaltungsträgern realisiert werden. In diesem Fall kann das Bauelement auf der Vorderseite des plattenförmigen Schaltungsträgers montiert sein und das Heizelement auf der Rückseite des Schaltungsträgers, wobei es dem Bauelement gegenüberliegt. Durch das Gegenüberliegen sind ebenfalls wie bei der benachbarten Anordnung kurze Wärmeübertragungswege sichergestellt.

Um die Wärmeübertragung vorteilhaft weiter zu verbessern, kann gemäß einer weiteren Ausgestaltung der Erfindung vorgesehen werden, dass das Heizelement mit einem Leitpfad in Berührung steht. Der Leitpfad ist dadurch spezifiziert, dass er die Wärme besser leitet als der Schaltungsträger. Mit anderen Worten wird die Wärme über den Leitpfad schneller von dem Heizelement zu den auszubildenden Kontakten transportiert. Deswegen muss der Leitpfad mit den auszubildenden Kontakten oder zumindest dem Bauelement und damit indirekt den auszubildenden Kontakten in Berührung stehen. Zwischen dem Leitpfad und den elektrischen Kontakten kann auch eine elektrische Isolationsschicht vorgesehen werden, wenn die Übertragung eines elektrischen Stroms nicht gewünscht ist.

Der Leitpfad kann auf der Oberfläche des Schaltungsträgers vorgesehen sein oder im Inneren des Schaltungsträgers liegen. Die Anordnung des Leitpfades auf der Oberfläche bietet sich insbesondere an, wenn das Heizelement auf derselben Seite des Schaltungsträgers untergebracht ist, wie das Bauelement. Leitpfade, die im Inneren des Schaltungsträgers verlaufen, können insbesondere genutzt werden, um einen Leitpfad zwischen einem Bauelement auf der Vorderseite eines plattenförmigen Schaltungsträgers und einem Heizelement auf der Rückseite dieses Schaltungsträgers zu schaffen. Vorteilhaft ist es dabei, dass als Leitpfade auch die elektrisch leitfähigen Leiterbahnen verwendet werden, die zur Kontaktierung der elektrischen Kontakte zur Verfügung stehen. Diese sind üblicherweise metallisch und weisen daher ein gutes Wärmeleitvermögen auf. Wenn das Heizelement mit diesen Leiterbahnen thermisch kontaktiert wird, kann die Wärme somit direkt in die auszubildenden elektrischen Kontakte eingeleitet werden. Die Leiterbahnen können hierbei vollständig den Leitpfad bilden oder thermisch mit einem Leitpfad kontaktiert werden, welcher allein zur Leitung von Wärme, jedoch nicht an der Ausbildung der elektrischen Schaltung beteiligt ist. Die zum Einsatz kommenden erfindungsgemäßen Heizelemente werden im Folgenden näher beschrieben.

Gemäß einer Ausgestaltung des Heizelementes kann in dessen Gehäuse eine Öffnung vorgesehen sein, die die Kavität mit der Umgebung des Heizelementes verbindet. Dies ist von Vorteil, wenn in der Kavität eine reaktive Substanz verwendet wird, bei deren exothermer Reaktionen eine Gasentwicklung zu verzeichnen ist. Über die Öffnung kann ein Druckausgleich mit der Umgebung erfolgen, so dass das Gehäuse nicht druckfest ausgelegt werden muss. Außerdem kann über die Öffnung erreicht werden, dass eine exotherme Reaktion mit Sauerstoff auf der Umgebung stattfinden kann wenn der Sauerstoff durch die Öffnung in das Gehäuse gelangt. Über die Größe der Öffnung kann damit auch die Geschwindigkeit der exothermen Reaktionen eingestellt werden, da die Sauerstoffzufuhr zur reaktiven Substanz von dem Öffnungsquerschnitt abhängt. Dieser Effekt kann vorrangig für exotherme Reaktionen genutzt werden, die ohne eine Gasentwicklung in der Kavität ablaufen und daher keinen Überdruck in der Kavität erzeugen.

Gemäß einer anderen Ausgestaltung der Erfindung ist vorgesehen, dass die reaktive Substanz in einem feinporigen Matrixmaterial verteilt ist. Hierdurch kann eine gleichmäßige Verteilung der reaktiven Substanz in der Kavität erreicht werden. Über die offenen Poren ist weiterhin ein Druckausgleich oder eine Sauerstoffzufuhr zu der reaktiven Substanz möglich. Die Verteilung der reaktiven Substanz ermöglicht es vorteilhaft, die Wärmeentwicklung besser dosieren zu können.

Gemäß einer zusätzlichen Ausgestaltung der Erfindung ist vorgesehen, dass die reaktive Komponente mit Sauerstoff exotherm reagieren kann, insbesondere eine Metall-Carbonyl-Verbindung ist. Diese Stoffgruppe hat den Vorteil, dass deren Schmelzpunkt durch eine geeignete Modifikation der chemischen Struktur eingestellt werden kann (hierfür kann das in der DE 10 2009 013 919 A1 beschriebene Verfahren angewendet werden). Auf diese Weise lässt sich die reaktive Komponente vorteilhaft auf das Material des elektrischen Kontaktes, insbesondere den Lotwerkstoff, maßschneidern, mit dem sie zur Verwendung kommen soll. Die Reaktion mit Sauerstoff hat weiterhin den Vorteil, dass hierzu der Luftsauerstoff zur Verfügung gestellt werden kann. Dadurch, dass dieser Luftsauerstoff durch die Metall-Carbonyl-Verbindung verbraucht wird, stellt ein solcher Zusatzwerkstoff gleichzeitig einen Oxidationsschutz für andere Komponenten des Lotwerkstoffes dar. Dies macht die Notwendigkeit entbehrlich, den Lötprozess in einem Schutzgas, wie z. B. Stickstoff, durchzuführen. Hierdurch lässt sich vorteilhaft ein weiterer Gewinn an Wirtschaftlichkeit bei Verwendung des erfindungsgemäßen Zusatzwerkstoffes erzielen.

Weiterhin ist es vorteilhaft, wenn die reaktive Komponente aus einem einen ersten Stoff und einen zweiten Stoff enthaltenden Gemisch besteht, wobei beide Stoffe unabhängig voneinander mit Sauerstoff exotherm reagieren können. Hierdurch ist vorteilhaft eine genauere Einstellung der während des Lötprozesses ablaufenden Reaktionen möglich. Besonders vorteilhaft ist es, wenn der erste Stoff eine Initiatorverbindung, insbesondere eine Metall-Carbonyl-Verbindung ist, die eine geringere Temperatur T₁ zur Zersetzung der Initiatorverbindung aufweist als der zweite Stoff, mit einer diesbezüglichen Temperatur T₂. Damit der erste Stoff als Initiatorverbindung wirken kann, muss die Zersetzung des ersten Stoffes bei der Temperatur T₁ ausreichen, um eine exotherme Reaktion des zweiten Stoffes einzuleiten. Weiterhin ist es möglich, dass die Zersetzungsprodukte des ersten Stoffes in einem weiteren Reaktionsschritt exotherm reagieren. Die exotherme Reaktion findet vorzugsweise mit Sauerstoff statt.

Durch die Verwendung einer Initiatorverbindung kann vorteilhaft der notwendige Wärmeeintrag in das Heizelement zum Auslösen beispielsweise eines Lötprozesses weiter verringert werden. Dies bedeutet, dass beispielsweise in einem Reflow-Lötofen die Prozesstemperaturen abgesenkt werden können. Der Wärmeeintrag beim Lötvorgang muss lediglich erreichen, dass die Initiatorverbindung reagiert, wodurch die oben beschriebene Kettenreaktion in Gang gesetzt wird und auf diese Weise zunächst der zweite Stoff exotherm reagiert und hierdurch das Lotmaterial aufgeschmolzen wird.

Eine weitere vorteilhafte Ausführungsform der Erfindung erhält man, wenn in dem Heizelement ein Sauerstoffträger, insbesondere ein Peroxid enthalten ist, das/der bei besagter Temperatur T₁ (oder je nach Anwendungsfall bei T₂) Sauerstoff abgibt. Dies hat den Vorteil, dass der für die exotherme Reaktion notwendige Sauerstoff direkt in dem Heizelement zur Verfügung gestellt wird und auf diese Weise notwendige Diffusionsprozesse des Sauerstoffes aus der Atmosphäre in das Innere des Heizelementes nicht notwendig sind. Außerdem kann, wenn dies aus anderen Gründen notwendig ist, in Schutzatmosphäre unter Sauerstoffabschluss gelötet werden, da der Reaktionspartner für die exotherme Reaktion im Inneren des Heizelementes zur Verfügung gestellt wird.
Vorteilhaft kann weiterhin vorgesehen werden, dass an dem Gehäuse des Heizelementes eine Befestigungsvorrichtung für eine Montage auf der elektronischen Baugruppe vorgesehen ist. Hier kommen insbesondere mechanische Vorrichtungen infrage, die auch eine lösbare Verbindung des Heizelementes auf dem Schaltungsträger oder einem Bauelement ermöglichen können. Hierbei können die Dimensionen von auf Schaltungsträger üblichen Aufnahmen berücksichtigt werden, so dass auf standardisierte Produkte und Fertigungsverfahren zurückgegriffen werden kann. Auch die Bestückung des Schaltungsträgers mit dem Heizelement wird dadurch vorteilhaft erleichtert.

Beispielsweise kann die Befestigungsvorrichtung vorteilhaft einen Stift aufweisen, der von der Montageseite des Heizelementes abragt. Dieser kann dann in ein hierfür vorgesehenes Durchgangsloch oder auch in ein Sackloch im Schaltungsträger gesteckt werden. Hierbei kann eine Passung gewählt werden, die eine Fixierung des Heizelementes während des Fertigungsverfahrens gewährleistet und eine anschließende Trennung des Heizelementes von dem Schaltungsträger erlaubt. Vorteilhaft kann sich die Kavität mit der reaktiven Substanz auch in den Stift hinein erstrecken. Dies hat den Vorteil, dass eine Übertragung von Wärme über den Stift in den Schaltungsträger beschleunigt wird. Hierdurch können auch größere Wärmemengen über den Schaltungsträger hin zu den auszubildenden Kontakten transportiert werden.

Das erfindungsgemäße Verfahren kann folgendermaßen weiter ausgebildet werden. Die Temperaturerhöhung beim Ausbilden der elektrischen Kontakte kann vorteilhaft in einem Lötofen erzeugt werden. Dabei werden als elektrische Kontakte Lötverbindungen zwischen den Bauelementen und dem Schaltungsträger erzeugt. Erfindungsgemäß ist auf dem Schaltungsträger mindestens ein Bauelement vorgesehen. Üblicherweise handelt es sich jedoch um mehrere Bauelemente. Das Heizelement kann erfindungsgemäß zur Einleitung von Wärme in eines von mehreren Bauelementen oder auch in mehrere Bauelemente genutzt werden. Selbstverständlich können auch mehrere Heizelemente zum Einsatz kommen. Im Folgenden wird die Verwendung der erfindungsgemäßen Heizelemente in einem Lötofen erläutert, wobei die Funktion des Heizelementes analog auch in anderen thermischen Fügeverfahren ablaufen kann.

Durch die Verwendung definiert instabiler, chemischer Verbindungen (nämlich der reaktiven Substanz) beim Lötprozess wird Energie dadurch frei, dass eine exotherme Reaktion abläuft. Auf diese Weise tritt während der chemischen Umsetzung in der Lötverbindung eine Temperaturerhöhung auf. Durch diese Form der Energiefreisetzung wird zwangsläufig die benötigte, von außen zugeführte Wärmemenge bis zum Schmelzen des Lotes reduziert. Die Reaktion und die damit erreichte zusätzliche Energie bleibt also lokal auf den Bereiche der herzustellenden elektrischen Kontakte(Lötverbindungen) begrenzt und hat daher kaum Auswirkungen auf die Zuverlässigkeit der umgebenden Materialien (Leiterplatte, Bauelemente). Damit wird eine geringere thermische Belastung der Bauelemente gewährleistet, wodurch vorteilhaft die Auswahl an Bauelementen steigt. Außerdem ist eine geringere Wärmezufuhr durch den Lötofen notwendig, wodurch vorteilhaft Energie gespart wird. Insbesondere können dadurch bleifreie Lötlegierungen, wie z. B. Lotlegierungen auf SnAgCu-Basis unter Bedingungen verarbeitet werden, wie diese bei den bisher eingestzten SnPb-Loten üblich waren. Dabei können die gebräuchlichen Lötanlagen, Basismaterialien, Bauelemente und auch Reparatursysteme verwendet werden. Außerdem wird durch Verringerung der Temperaturbelastung beim Löten die Baugruppenzuverlässigkeit und somit die Lebensdauer der gefertigten Baugruppen erhöht, wodurch Qualitätsprobleme vermieden werden können. Auch die Qualität der ausgebildeten Lötverbindungen kann vorteilhaft verbessert werden, da durch die geringere Temperaturbelastung während des Lötens auch die Oxidation der Lötstellen verringert wird. Deswegen kann auch der Einsatz von Stickstoff beim Löten entfallen, was zu weiteren Kostensenkungen führt.

Durch die geringere, notwendige Energiemenge, die der zu lötenden Baugruppe zugeführt werden muss, verkürzen sich weiterhin die Lötzeiten, weswegen vorteilhaft die Durchlaufraten innerhalb einer bestehenden Fertigungslinie erhöht werden können. Hierdurch lässt sich ein weiterer Wirtschaftlichkeitsgewinn erreichen. Auch Reparaturprozesse können weitgehend vereinfacht und verkürzt werden. Durch die Herabsetzung des Schmelzpunktes des Lotwerkstoffes ist außerdem der Einsatz bei doppelseitig bestückten Leiterplatten besonders vorteilhaft. Da der Schmelzpunkt der ausgebildeten Lötverbindungen wesentlich höher als die Prozesstemperatur liegt, kann ein Erweichen der Lötverbindungen auf der Vorderseite der Leiterplatte ausgeschlossen werden, wenn in einem zweiten Durchgang die Lötverbindungen auf der Rückseite hergestellt werden.

Wie bereits erwähnt, kann das Heizelement des Schaltungsträgers auch an einer Stelle der elektronischen Baugruppe eingesetzt werden, die in dem Lötofen eine geringere Temperaturerhöhung erfährt, als andere Stellen der elektronischen Baugruppe. Hierdurch erfährt die elektronische Baugruppe eine gleichmäßigere Erwärmung, so dass vorteilhaft Regionen der elektronischen Baugruppe, die sich schneller erwärmen, nicht mehr überhitzt werden.

Zuletzt kann das erfindungsgemäße Verfahren auch dazu angewendet werden, an einer elektronischen Baugruppe ein Reparaturlöten durchzuführen. Zu diesem Zweck wird ein Heizelement auf der elektronischen Baugruppe platziert, wobei hierbei auch Einbauplätze genutzt werden können, die während des Fertigungsverfahrens für Heizelemente zur Verfügung standen. Die Heizelemente können sowohl für das Entlöten eines defekten Bauelementes als auch zum Verlöten eines Austauschelementes verwendet werden. Im Falle des Entlötens werden die Lötverbindungen mithilfe der durch das Heizelement eingebrachten Wärme aufgeschmolzen, so dass dieses von dem Schaltungsträger abgehoben werden kann. Im Falle eines Verlötens des neuen Bauteils arbeitet das Heizelement in der bereits beschriebenen Weise.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Es zeigen
- Figur 1: ein Ausführungsbeispiel für die erfindungsgemäße Baugruppe mit einem Ausführungsbeispiel für das erfindungsgemäße Heizelement geschnitten,
- Figur 2: ein Ausführungsbeispiel des erfindungsgemäßen Verfahrens in einem Lötofen mit einem diesem zugeordneten ortsabhängigen (Laufvariable x der Baugruppe) Temperaturprofil (Temperatur T),
- Figur 3: ein anderes Ausführungsbeispiel der erfindungsgemäßen Baugruppe mit Ausführungsbeispielen des erfindungsgemäßen Heizelementes geschnitten und
- Figur 4: die elektronische Baugruppe gemäß Figur 3, vorbereitet für ein Reparaturlöten, geschnitten.

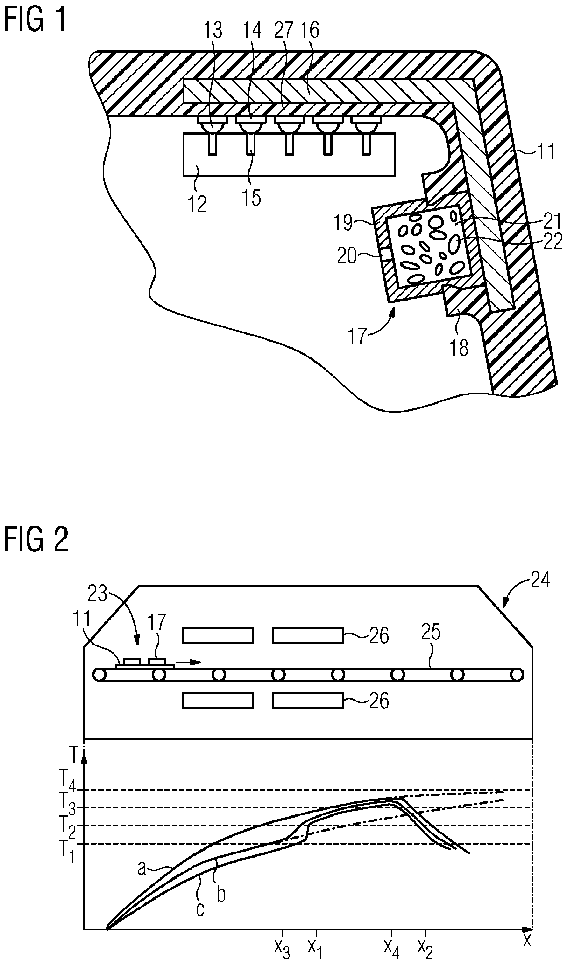

In Figur 1 ist eine elektronische Baugruppe dargestellt. Ein Schaltungsträger 11 besteht aus einem Gehäuse, welches lediglich als Ausschnitt dargestellt ist. In diesem Gehäuse ist ein Bauelement 12 auf der Innenwand befestigt, und zwar mittels Kontakten 13, welche als Lötstellen ausgebildet sind. Der Schaltungsträger weist hierfür Kontaktflächen 14 auf, wobei das Bauelement 12 mit Kontaktdrähten 15 auf die Kontaktflächen 14 aufgesetzt ist.

Im Inneren des Schaltungsträgers 11 ist ein Leitpfad 16 vorgesehen, der aus Kupfer besteht und daher gut wärmeleitend ist. Dieser Leitpfad steht mit einem Heizelement 17 in Kontakt, welches in einer Aufnahme 18 lösbar mit dem Schaltungsträger 11 verbunden ist. Dadurch, dass das Heizelement 17 mit dem Leitpfad 16 in Kontakt steht, kann in dem Heizelement 17 erzeugte Wärme gut auf den Leitpfad 16 übertragen werden. Der Leitpfad 16 erstreckt sich auch unterhalb der Kontaktflächen 14, so dass diese durch den Leitpfad eine Erwärmung erfahren können. Das Material des Gehäuses ist aus Kunststoff und damit elektrisch isolierend und bildet zwischen den Kontaktflächen 14 und dem Leitpfad 16 eine im Vergleich zur Dicke des Leitpfades 16 dünne Isolationsschicht 27 aus.

Das Heizelement 17 weist ein Gehäuse 19 auf, welches mit einer Öffnung 20 versehen ist. In einer durch das Gehäuse ausgebildeten Kavität befindet sich ein offenporiges Matrixmaterial 21, in dessen Poren 22 eine nicht näher dargestellte reaktive Substanz vorhanden ist. Bei dem Matrixmaterial handelt es sich um ein offenporiges Material, so dass ein Druckausgleich erfolgen kann, wenn die exotherme Reaktion der reaktiven Substanz mit einer Gasentwicklung von statten geht.

In Figur 2 ist der Ablauf des erfindungsgemäßen Verfahrens dargestellt, wobei eine Baugruppe 23 durch einen Lötofen 24 geführt wird. Hierzu ist ein Fördervorrichtung 25 angedeutet, wobei diese die Baugruppe 23 mit konstanter Geschwindigkeit durch den Lötofen 24 führt. Im Lötofen sind weiterhin Strahlungsheizungen 26 installiert, die die Baugruppe erwärmen.

Der Temperaturverlauf T über einer Laufvariablen x, die den Weg der Baugruppe 23 in dem Lötofen beschreibt, ist in einem Diagramm unterhalb des Lötofens 24 in Figur 2 dargestellt, und zwar maßstabgerecht zur Darstellung des Lötofens 24 selbst. Die Kurven a, b und c stellen den Temperaturverlauf unterschiedlicher Regionen der elektronischen Baugruppe 23 dar.

Kurve a beschreibt den Temperaturverlauf in einer Region des Schaltungsträgers 23, der eine geringe Wärmekapazität aufweist und sich daher schnell erwärmt. In dieser Region sind keine Heizelemente angeordnet. Zu erkennen ist, dass der Temperaturverlauf sich asymtotisch an eine Prozesstemperatur T₄ annähert, die der im Lötofen herrschenden Temperatur entspricht. Dabei überschreitet die Region auch die zum Aufschmelzen der elektrischen Kontakte (Lötverbindungen) notwenige Fügetemperatur T₃ an der Stelle x₁ des Lötofens.

Der Temperaturverlauf einer Region mit größerer Wärmekapazität ist in Kurve b dargestellt. Würde in dieser Region keines der erfindungsgemäßen Heizelemente vorgesehen werden, so würde sich der strichpunktiert eingezeichnete, von der Kurve b ausgehende Temperaturverlauf einstellen, weswegen die Fügetemperatur T₃ verhältnismäßig spät an der Stelle x₂ erreicht werden würde. Die Region, die durch die Kurve a dargestellt wird, wäre zu diesem Zeitpunkt schon viel zu stark erwärmt worden und hätte die Prozesstemperatur T₄ fast erreicht. Um dies zu vermeiden wird das erfindungsgemäße Heizelement eingesetzt, so dass bei Überschreiten der Reaktionstemperatur T₁ der reaktiven Substanz an der Position x₃ ein zusätzlicher Wärmeeintrag in die Region der elektronischen Baugruppe erfolgt und die Fügetemperatur T₃ auch ungefähr an der Position X₁ erreicht wird, wie dies für die erstgenannte Region (Kurve a) der Fall ist.

Der Temperaturverlauf gemäß der Kurve c wird erreicht, wenn die reaktive Substanz aus zwei Komponenten besteht. Die erste Komponente, die vorzugsweise durch eine Metall-Karbonyl-Verbindung zur Verfügung gestellt wird, kommt als Initiator zum Einsatz, so dass die Temperatur bei der Reaktionstemperatur T₁ schnell ansteigt und eine Reaktionstemperatur T₂ der zweiten Komponente relativ schnell erreicht. Die zweite Komponente, die beispielsweise durch ein leicht oxidierendes Metall zur Verfügung gestellt werden kann, erzeugt im weiteren Verlauf dann die zusätzliche nötige Wärme, so dass auch die Region, die durch die Kurve c dargestellt ist, ungefähr an der Position X₁ die Fügetemperatur T₃ erreicht.

Daher lassen sich alle Lötverbindungen bereits an der Stelle x₁ herstellen. Kurz dahinter kann die Temperatur an der Stelle x₄ bereits heruntergefahren werden. Damit kommt es nicht zu der thermischen Belastung, die strichpunktiert an der Stelle x₂ dargestellt ist.

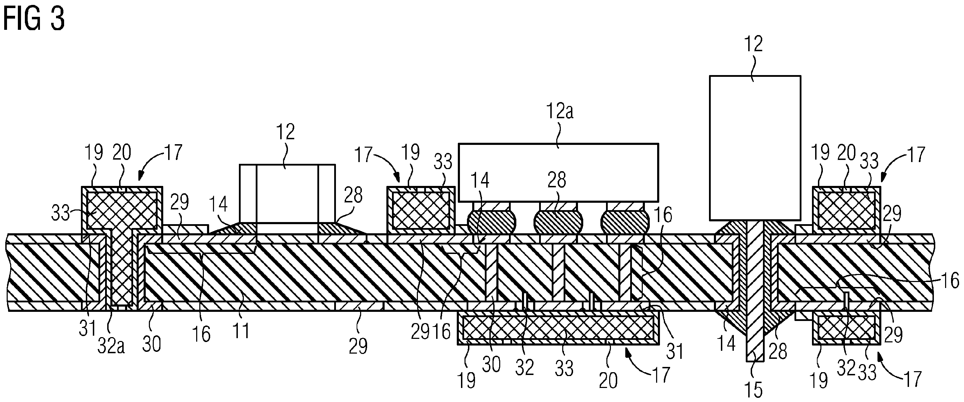

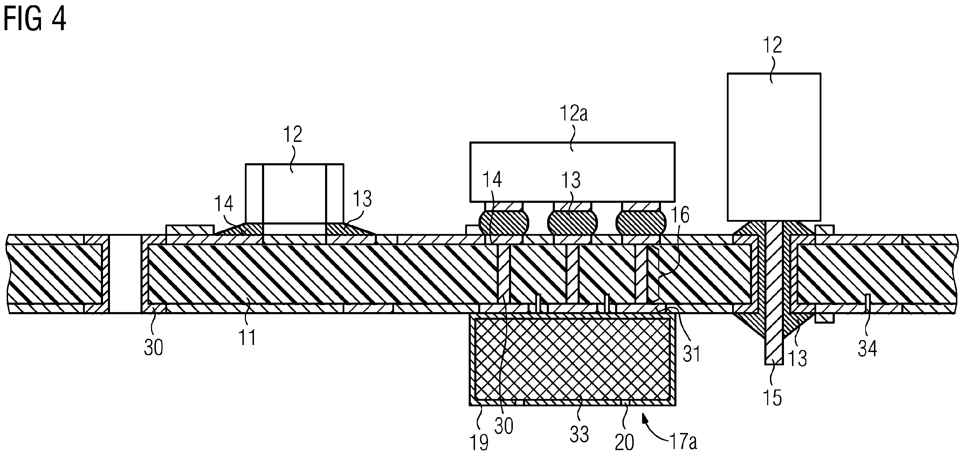

In Figur 3 ist ein Schaltungsträger 11 in Form einer Leiterplatte dargestellt. Dieser weist Kontaktflächen 14 auf, auf denen Lotdepots 28 zur Verbindung der Bauelemente 12 vorgesehen sind. Diese Lotdepots 28 bilden später die Kontakte 13 aus, wie sich Figur 4 entnehmen lässt. Die Kontaktflächen 14 sind weiterhin mit Leiterbahnen 29 verbunden, die ebenfalls in Figur 3 angedeutet sind. Diese sind Teil nicht näher dargestellter elektrischer Schaltkreise auf dem Schaltungsträger 11. Die Kontaktflächen 14, die Leiterbahnen 29 und Durchkontaktierungen 30 bilden die gut thermisch leitfähigen Leitpfade 16, wobei jeweils an deren einen Enden die Heizelemente 17 und an deren anderen Enden die Lotdepots 28 liegen, die die späteren Kontakte 13 (vergleiche Figur 4) ausbilden.

Bei der in Figur 3 dargestellten Leiterplatte 11 sind die Heizelemente 17 bereits montiert. Diese weisen an ihrer Montageseite 31 zu diesem Zweck Stifte 32 auf, die in hierzu geeignete Löcher (34 in Figur 4) in der Leiterplatte eingesteckt werden. Der Stift 32a ist hohl ausgebildet, so dass sich eine reaktive Substanz 33 auch in den Stift hinein erstrecken kann.

In Figur 4 ist die elektronische Baugruppe nach der Herstellung gemäß Figur 3 dargestellt. Die Heizelemente wurden entfernt, wobei noch eine Bohrung 34 zu erkennen ist, in die eines der Heizelemente 17 eingesteckt gewesen ist.

In Figur 4 ist weiterhin ein Aufbau für ein Reparaturlöten zu erkennen. Das Bauelement 12a soll entlötet werden, wobei die Kontakte 13 zu diesem Zweck aufgeschmolzen werden müssen. Zu diesem Zweck wird das Heizelement 17a auf der dem Bauelement 12a gegenüber liegenden Seite der Leiterplatte 11 montiert, wobei die Wärme ausreicht, um die Lötverbindungen aufzuschmelzen. In gleicher Weise kann anschließend ein Ersatzbauelement mit der Leiterplatte verlötet werden (nicht dargestellt) .

Das Reparaturlöten (das heißt, das Entlöten des defekten Bauelementes 12a sowie das Verlöten eines neuen Bauelementes) kann auch in einem Ofen (nicht dargestellt) durchgeführt werden. Dieser kann einen Teil der zum Reparaturlöten erforderlichen Wärmemenge zur Verfügung stellen, wobei die im Lötofen herrschenden Temperaturen gering genug gewählt werden müssen, damit die Kontakte 13 der anderen Bauelemente 12 unversehrt bleiben. In diesem Fall muss durch das Heizelement 17a lediglich die erforderliche Wärme bereitgestellt werden, um die Region der Leiterplatte, in der das auszuwechselnde Bauelement 12a liegt, stärker zu erwärmen.

Von den vielen instabilen organischen und anorganischen Verbindungen, die sich als reaktive Substanz eigenen, sollen Metallcarbonyle genauer beschrieben werden. Diese Verbindungsklasse zeichnet sich durch die Anwesenheit eines oder mehrerer Metallatome im Mol aus, um die je nach Elektronenkonfiguration CO-Gruppierungen angeordnet sind. Entsprechend den Reaktionsbedingungen und Ausgangsstoffe erhält man sogenannte "homoleptische"(nur eine Ligandenart) oder "heteroleptische" Carbonylverbindungen (unterschiedliche Ligandenarten). Werden unterschiedliche Metalle als Zentralatome verwendet, spricht man von "isoleptischen" Carbonylen bzw. Komplexen. Es können sich dabei einkernige Verbindungen bilden, die unter Energieeinwirkung weiter zu binären Carbonylverbindungen reagieren können. Bei der Herstellung selbst geht man von einem fein verteilten Metall oder Metallgemisch aus, an dem direkt CO unter entsprechenden Bedingungen angelagert wird. Die von der Ausbeute her besonders vorteilhaften Synthesemöglichkeiten über die entsprechenden Halogenverbindungen sind wegen möglicher Verunreinigungen der Endprodukte nicht angewendet worden.

Besonders leicht reagiert Nickel mit CO. Bei 80°C erfolgt die Umsetzung bei Normaldruck mit befriedigender Ausbeute. Vorteilhaft ist dafür ein rotierendes Reaktionsgefäß bei dem die Achse horizontal angeordnet ist.

Nachfolgend soll auch der Reaktionsablauf am Beispiel einer Cobaltverbindung dargestellt werden:

Co + 4 CO → Co(CO)₄

Da die gebildete einkernige Verbindung relativ flüchtig ist und für die beabsichtigte Anwendung möglichst feste Stoffe vorliegen sollen, die aber einen möglichst definierten Zersetzungspunkt zwischen 60°C und 80°C aufweisen sollen, wurden das zweikernige bzw. vierkernige Cobaltcarbonyl bevorzugt. Die Darstellung wird nachstehend angedeutet:

2 Co(CO)₄ → Co₂(CO)₈

Die Umsetzung erfolgt unter Energiezufuhr mit oder ohne Lösungsmittel und definierten Druckverhältnissen. Die Energiezufuhr kann durch Wärme oder UV-Einwirkung erfolgen (Thermolyse oder Fotolyse). Je nach verwendetem Metall ist die fotolytische Stabilität unterschiedlich. So sind Carbonyle des Ru und Os besonders instabil.

Das aus dem Cobalttetracarbonyl hergestellte Dimer hat einen Schmelzpunkt von etwa 100°C bei dem auch die Zersetzung erfolgt, was für höherschmelzende Legierungen Anwendung finden kann.

Sollte die gewählte Carbonylverbindung für den geplanten Anwendungsfall zu reaktiv sein oder der Schmelzpunkt zu niedrig erscheinen, ist es möglich, an derartige Verbindungen vorhandene CO-Liganden gegen andere Strukturen, z.B. Cyclopentadien auszutauschen, wodurch eine gewisse Stabilisierung des Systems erfolgt. Die sich ergebenden neuen Verbindungen zeigen in der bezeichneten Art ein abweichendes Verhalten. In den Figuren 5 und 6 sind zwei Beispiele dafür dargestellt, wobei es sich lediglich um modellhafte Darstellungen handelt, deren exakter molekularer Aufbau noch nicht abschließend geklärt ist. Weitere Details dazu müssten im Bedarfsfall experimentell in Abhängigkeit der Aufgabenstellung ermittelt werden.

Es hat sich auch bei den Versuchen herausgestellt, dass die Energieabgabe nicht plötzlich in einem sehr kurzen Zeitraum erfolgt, sondern über die chemische Struktur des verwendeten Initiators gesteuert werden kann. Die erzielten Ergebnisse setzen voraus, dass der Lötprozess in normaler sauerstoffhaltiger Atmosphäre erfolgt und die Öffnung in dem Gehäuse des Heizelementes eine genügende Sauerstoffzufuhr erlaubt. Über den Öffnungsquerschnitt kann eine Dosierung der Wärmeentwicklung erfolgen. Wenn der Wunsch besteht in einer Inertgasatmosphäre zu arbeiten, ist für die Anwesenheit eines geeigneten Sauerstoffträgers wie z.B. der vorstehend genannten Peroxide zu sorgen.

Die Verfügbarkeit der Metallpulver als Handelsprodukt ist gegeben. Oligomere Carbonyle sind zwar als Handelsprodukte nicht bekannt, können aber durch den Fachmann mit Hilfe von Literaturangaben selbst angefertigt werden.

## Patentansprüche

1. Heizelement mit einer Montageseite (31) für eine SMD-Montage,
**dadurch gekennzeichnet,**
**dass** das Heizelement ein Gehäuse (19) aufweist, welches eine Kavität umschließt, in der sich eine reaktive Substanz (33) befindet, die bei einer Reaktionstemperatur T₁ exotherm reagiert.

2. Heizelement nach Anspruch 1,
**dadurch gekennzeichnet,**
**dass** in dem Gehäuse eine Öffnung (20) vorgesehen ist, die die Kavität mit der Umgebung des Heizelementes verbindet.

3. Heizelement nach Anspruch 2,
**dadurch gekennzeichnet,**
**dass** die reaktive Substanz (33) in einem offenporigen Matrixmaterial (21) verteilt ist.

4. Heizelement nach einem der voranstehenden Ansprüche,
**dadurch gekennzeichnet,**
**dass** die reaktive Substanz eine Metall-Carbonyl-Verbindung enthält.

5. Heizelement nach einem der voranstehenden Ansprüche,
**dadurch gekennzeichnet,**
**dass** die reaktive Substanz aus einem einen ersten Stoff und einen zweiten Stoff enthaltenden Gemisch besteht, wobei beide Stoffe unabhängig voneinander mit Sauerstoff exotherm reagieren können.

6. Heizelement nach einem der voranstehenden Ansprüche,
**dadurch gekennzeichnet,**
**dass** der reaktiven Substanz ein Oxidationsmittel, insbesondere ein Peroxid beigemengt ist, der/das bei besagter Reaktionstemperatur T₁ Sauerstoff abgibt.

7. Heizelement nach einem der voranstehenden Ansprüche,
**dadurch gekennzeichnet,**
**dass** an dem Gehäuse (19) eine Befestigungsvorrichtung für eine Montage auf der elektronischen Baugruppe (23) vorgesehen ist.

8. Heizelement nach Anspruch 7,
**dadurch gekennzeichnet,**
**dass** die Befestigungsvorrichtung einen Stift (32) aufweist, der von der Montageseite (31) des Heizelementes abragt.

9. Heizelement nach Anspruch 8,
**dadurch gekennzeichnet,**
**dass** sich die Kavität mit der reaktiven Substanz (33) in den Stift (32) hinein erstreckt.

10. Elektronische Baugruppe, aufweisend einen Schaltungsträger (23) und ein Bauelement (12),
**dadurch gekennzeichnet,**
**dass** auf der elektronischen Baugruppe ein Heizelement (17) nach einem der voranstehenden Ansprüche befestigt ist.

11. Elektronische Baugruppe nach Anspruch 10,
**dadurch gekennzeichnet,**
**dass** das Heizelement (17) dem Bauelement benachbart auf dem Schaltungsträger (11) befestigt ist.

12. Elektronische Baugruppe nach Anspruch 11,
**dadurch gekennzeichnet,**
**dass** der Schaltungsträger (11) plattenförmig ausgeführt ist, das Bauelement (12) auf seiner Vorderseite moniert ist und das Heizelement (17) auf der Rückseite des Schaltungsträgers (11) derart montiert ist, dass es dem Bauelement (12) gegenüberliegt.

13. Elektronische Baugruppe nach einem der Ansprüche 10 bis 12,
**dadurch gekennzeichnet,**
**dass** das Heizelement (17) mit einem Leitpfad (16) in Berührung steht, wobei der Leitpfad (16)
• Wärme besser leitet, als der Schaltungsträger (11),
• mit den auszubildenden Kontakten (13) oder dem Bauelement (12) in Berührung steht oder unter Zwischenschaltung einer Isolierschicht (27) an diese angegrenzt.

14. Elektronische Baugruppe nach Anspruch 13,
**dadurch gekennzeichnet,**
**dass** der Leitpfad (16) ganz oder teilweise aus elektrisch leitfähigen Leiterbahnen (29) zur Kontaktierung der elektrischen Kontakte (13) besteht.

15. Verfahren zum Erzeugen einer elektronischen Baugruppe (23), aufweisend einen Schaltungsträger (23) und ein Bauelement (12), wobei
• das Bauelement (12) auf dem Schaltungsträger (11) platziert wird und
• elektrische Kontakte (13) zwischen dem Schaltungsträger (11) und dem Bauelement (12) durch eine Temperaturerhöhung bei einer Fügetemperatur T₃ ausgebildet werden,
**dadurch gekennzeichnet,**
**dass** vor dem Ausbilden der elektrischen Kontakte ein Heizelement (17) nach Anspruch 1 auf der elektronischen Baugruppe (23) befestigt wird, welches eine Kavität aufweist, in der eine reaktive Substanz (33) vorgesehen ist, die bei einer Reaktionstemperatur T₁ exotherm reagiert, wobei
• die Reaktionstemperatur T₁ kleiner ist, als die Fügetemperatur T₃ und
• die aus der exothermen Reaktion resultierende Reaktionswärme vom Heizelement (17) auf die sich ausbildenden elektrischen Kontakte (13) übertragen wird.

16. Verfahren nach Anspruch 15,
**dadurch gekennzeichnet,**
**dass** das Heizelement nach dem Ausbilden der elektrischen Kontakte (13) von der elektronischen Baugruppe entfernt wird.

17. Verfahren nach einem der Ansprüche 15 oder 16,
**dadurch gekennzeichnet,**
**dass** die Temperaturerhöhung beim Ausbilden der elektrischen Kontakte (13) in einem Lötofen erzeugt wird.

18. Verfahren nach Anspruch 17,
**dadurch gekennzeichnet,**
**dass** das das Heizelement (17) auf dem Schaltungsträger (11) an einer Stelle der elektronischen Baugruppe eingesetzt wird, die in dem Lötofen eine geringere Temperaturerhöhung erfährt, als andere Stellen der elektronischen Baugruppe (23).

19. Verfahren nach einem der Ansprüche 15 oder 16,
**dadurch gekennzeichnet,**
**dass** das Heizelement (17) eingesetzt wird, um die elektronische Baugruppe (23) lokal an einer Stelle zu erwärmen, wo das Bauelement (12) ein defektes Bauelement ersetzen soll.

20. Verfahren nach einem der Ansprüche 15 bis 19,
**dadurch gekennzeichnet,**
**dass** ein Heizelement (17) nach einem der Ansprüche 1 bis 9 oder eine Baugruppe (23) nach einem der Ansprüche 10 bis 15 eingesetzt wird.

## Claims

1. Heating element having a mounting side (31) for SMD mounting,
**characterized**
**in that** the heating element has a housing (19) which encloses a cavity in which a reactive substance (33) that reacts exothermically at a reaction temperature T₁ is located.

2. Heating element according to Claim 1,
**characterized**
**in that** an opening (20) which connects the cavity to the surroundings of the heating element is provided in the housing.

3. Heating element according to Claim 2,
**characterized**
**in that** the reactive substance (33) is distributed in an open-pore matrix material (21).

4. Heating element according to one of the preceding claims,
**characterized**
**in that** the reactive substance contains a metal-carbonyl compound.

5. Heating element according to one of the preceding claims,
**characterized**
**in that** the reactive substance consists of a mixture containing a first substance and a second substance, it being possible for the two substances to react exothermically with oxygen independently of one another.

6. Heating element according to one of the preceding claims,
**characterized**
**in that** admixed with the reactive substance is an oxidizing agent, in particular a peroxide, which gives off oxygen at said reaction temperature T₁.

7. Heating element according to one of the preceding claims,
**characterized**
**in that** a fastening device for mounting on the electronic assembly (23) is provided on the housing (19).

8. Heating element according to Claim 7,
**characterized**
**in that** the fastening device comprises a pin (32) which protrudes from the mounting side (31) of the heating element.

9. Heating element according to Claim 8,
**characterized**
**in that** the cavity with the reactive substance (33) extends into the pin (32).

10. Electronic assembly, comprising a circuit carrier (23) and a component (12),
**characterized**
**in that** a heating element (17) according to one of the preceding claims is fastened on the electronic assembly.

11. Electronic assembly according to Claim 10,
**characterized**
**in that** the heating element (17) is fastened on the circuit carrier (11) alongside the component.

12. Electronic assembly according to Claim 11,
**characterized in that**
the circuit carrier (11) is configured in the form of a sheet, the component (12) is mounted on its front side and the heating element (17) is mounted on the rear side of the circuit carrier (11) in such a way that it is opposite from the component (12).

13. Electronic assembly according to one of Claims 10 to 12,
**characterized**
**in that** the heating element (17) is in contact with a conducting path (16), the conducting path (16)
• conducting heat better than the circuit carrier (11),
• being in contact with the contacts (13) to be formed or the component (12) or, by interposing an insulating layer (27), adjoining the latter.

14. Electronic assembly according to Claim 13,
**characterized**
**in that** the conducting path (16) consists entirely or partially of electrically conductive conductor tracks (29) for contacting the electrical contacts (13).

15. Method for producing an electronic assembly (23), comprising a circuit carrier (23) and a component (12),
• the component (12) being placed on the circuit carrier (11) and
• electrical contacts (13) between the circuit carrier (11) and the component (12) being formed by an increase in temperature with respect to a joining temperature T₃,
**characterized**
**in that**, before the forming of the electrical contacts, a heating element (17) according to Claim 1 is fastened on the electronic assembly (23), which heating element has a cavity in which there is provided a reactive substance (33) that reacts exothermically at a reaction temperature T₁,
• the reaction temperature T₁ being less than the joining temperature T₃ and
• the heat of reaction resulting from the exothermic reaction being transferred from the heating element (17) to the electrical contacts (13) forming.

16. Method according to Claim 15,
**characterized**
**in that**, after the forming of the electrical contacts (13), the heating element is removed from the electronic assembly.

17. Method according to either of Claims 15 and 16,
**characterized**
**in that** the increase in temperature when forming the electrical contacts (13) is produced in a soldering furnace.

18. Method according to Claim 17,
**characterized**
**in that** the heating element (17) on the circuit carrier (11) is used at a point of the electronic assembly that undergoes a lower increase in temperature in the soldering furnace than other points of the electronic assembly (23).

19. Method according to either of Claims 15 or 16,
**characterized**
**in that** the heating element (17) is used for heating up the electronic assembly (23) locally at a point where the component (12) is intended to replace a defective component.

20. Method according to one of claims 15 to 19,
**characterized**
**in that** a heating element (17) according to one of Claims 1 to 9 or an assembly (23) according to one of Claims 10 to 15 is used.

## Revendications

1. Elément chauffant, ayant un côté (31) de montage pour un montage de CMS,
**caractérisé**
**en ce que** l'élément chauffant a un boîtier (19), qui entoure une cavité, dans laquelle se trouve une substance (33) réactive, qui réagit exothermiquement à une température T₁ de réaction.

2. Elément chauffant suivant la revendication 1,
**caractérisé**
**en ce que** dans le boîtier est prévue une ouverture (20), qui met la cavité en communication avec les alentours de l'élément chauffant.

3. Elément chauffant suivant la revendication 2,
**caractérisé**
**en ce que** la substance (33) réactive est répartie dans une matière (21) de matrice à pores ouverts.

4. Elément chauffant suivant l'une des revendications précédentes,
**caractérisé**
**en ce que** la substance réactive contient un composé métal-carbonyle.

5. Elément chauffant suivant l'une des revendications précédentes,
**caractérisé**
**en ce que** la substance réactive est constituée d'un mélange contenant une première matière et une deuxième matière, les deux matières pouvant réagir, indépendamment l'une de l'autre, de manière exothermique sur l'oxygène.

6. Elément chauffant suivant l'une des revendications précédentes,
**caractérisé**
**en ce qu'**à la substance réactive est ajouté un agent oxydant, notamment un peroxyde, qui cède de l'oxygène à ladite température T₁ de réaction.

7. Elément chauffant suivant l'une des revendications précédentes,
**caractérisé**
**en ce que**, sur le boîtier (19), est prévu un système de fixation pour un montage sur le module (23) électronique.

8. Elément chauffant suivant la revendication 7,
**caractérisé**
**en ce que** le système de fixation a une broche (32), qui fait saillie du côté (31) de montage de l'élément chauffant.

9. Elément chauffant suivant la revendication 8,
**caractérisé**
**en ce que** la cavité, avec la substance (33) réactive, s'étend dans la broche (32).

10. Module électronique, ayant un support (23) de circuit et un composant (12),
**caractérisé**
**en ce qu'**un élément (17) chauffant, suivant l'une des revendications précédentes, est fixé sur le module électronique.

11. Module électronique suivant la revendication 10,
**caractérisé,**
**en ce que** l'élément (17) chauffant est fixé au voisinage du composant sur le support (11) de circuit.

12. Module électronique suivant la revendication 11,
**caractérisé**
**en ce que** le support (11) de circuit est réalisé sous la forme d'une plaquette, le composant (12) est monté sur sa face avant et l'élément (17) chauffant est monté sur la face arrière du support (11) de circuit, de manière à être opposé au composant (12).

13. Module électronique suivant l'une des revendications 10 à 12,
**caractérisé**
**en ce que** l'élément (17) chauffant est en contact avec un chemin (16) conducteur, le chemin (16) conducteur
• conduit mieux la chaleur que le support (11) de circuit
• est en contact avec les contacts (13) à constituer ou avec le composant (12) ou en est voisin avec interposition d'une couche (27) isolante.

14. Module électronique suivant la revendication 13,
**caractérisé**
**en ce que** le chemin (19) conducteur est constitué en tout ou partie de pistes (29) conductrices de l'électricité pour la mise en contact des contacts (13) électriques.

15. Procédé de production d'un module (23) électronique, comportant un support (23) de circuit et un composant (12), dans lequel
• on met le composant (12) sur le support (11) de circuit et
• on constitue des contacts (13) électriques entre le support (11) de circuit et le composant (12) par une élévation de température jusqu'à une température T₃ de jonction,
**caractérisé**
**en ce qu'**avant de constituer des contacts électriques, on fixe sur le module (23) électronique un élément (17) chauffant suivant la revendication 1, qui a une cavité, dans laquelle est prévue une substance (33) réactive réagissant de manière exothermique à une température T₁ de réaction, dans lequel
• la température T₁ de réaction est inférieure à la température T₃ de jonction et
• on transmet la chaleur de réaction provenant de la réaction exothermique de l'élément (17) chauffant aux contacts (13) électriques à constituer.

16. Procédé suivant la revendication 15,
**caractérisé**
**en ce que** l'on retire l'élément chauffant du module électronique après la constitution des contacts (13) électriques.

17. Procédé suivant l'une des revendications 15 ou 16,
**caractérisé**
**en ce que** l'on produit l'élévation de température à la constitution des contacts (13) électriques dans un four de brasage.

18. Procédé suivant la revendication 17,
**caractérisé**
**en ce que** l'on utilise l'élément (17) chauffant sur un support (11) de circuit à un emplacement du module électronique, qui subit, par le four de brasage, une élévation de température plus petite que d'autres endroits du module (23) électronique.

19. Procédé suivant l'une des revendications 15 ou 16,
**caractérisé**
**en ce que** l'on utilise l'élément (17) chauffant pour chauffer le module (23) électronique localement à un endroit où le composant (12) doit remplacer un composant défectueux.

20. Procédé suivant l'une des revendications 15 à 19,
**caractérisé**
**en ce que** l'on utilise un élément (17) chauffant suivant l'une des revendications 1 à 9 ou un module (23) suivant l'une des revendications 10 à 15.
